# EUROPEAN PATENT SPECIFICATION

(11) **EP 4 412 438 B1**
(45) Date of publication and mention of the grant of the patent: **02.07.2025**
(21) Application number: 23305137.4
(22) Date of filing: 02.02.2023
(51) Int. Cl.: H10N 60/01, H10N 60/10

(54) **METHOD FOR PRODUCING A SUPERCONDUCTING TRANSISTOR**
VERFAHREN ZUR HERSTELLUNG EINES SUPRALEITENDEN TRANSISTORS
PROCÉDÉ DE FABRICATION D'UN TRANSISTOR SUPRACONDUCTEUR

(43) Date of publication of application: 07.08.2024
(73) Proprietor: Commissariat à l'Energie Atomique et aux Energies Alternatives, 75015 Paris (FR)
(72) Inventor: NEMOUCHI, Fabrice, 38054 Grenoble Cedex 09 (FR); LEFLOCH, François, 38054 Grenoble Cedex 09 (FR); ZHANG, Shi-li, 11267 Stockholm (SE); ZHANG, Zhen, 19137 Sollentuna (SE)
(74) Representative: Brevalex

(56) References cited:
- JP-A- H02 194 661
- US-A1- 2020 161 422
- US-B1- 6 639 288

## Description

### TECHNICAL FIELD AND PRIOR ART

The present application relates to the field of quantum devices, and more particularly to a method for producing gate-tuned Josephson junctions, also known as Josephson Field-Effect Transistor (JoFET). More generally, the proposed method may be applied for the production of any type of superconducting transistor.

The document EP 3 654 394 A1 (also published as US 2020/161422 A1) discloses the production of transistors, particularly JoFETs, including source and drain made of a material capable of having superconducting properties. In this document, the superconducting regions are produced by the deposition of a metal material above a semiconductor material, and then a thermal annealing forming regions comprising a compound of the metal material and the semiconductor material.

US 6 639 288 B1 discusses the use of dummy gates in semiconductor manufacturing.

JP H02 194661 A shows an earlier generation superconducting transistor with a contiguous superconducting source-drain channel structure with a gate positioned over this structure.

It could be advantageous to use superconducting materials having a high critical temperature (Tc) because with such materials, a larger BCS (Bardeen-Cooper-Schrieffer) energy gap can be obtained, leading to a higher supercurrent, for a given temperature. However, the process disclosed in the document EP 3 654 394 A1 is not adapted for several superconducting material having a high Tc, like V₃Si.

### DESCRIPTION OF THE INVENTION

Therefore, there is a need to propose a new method for producing superconducting transistors, advantageously Josephson Field-Effect Transistors, which can be used for a large number of superconducting materials, especially for high-Tc superconducting materials.

It is thus proposed a method for producing a superconducting transistor comprising at least the steps of:
- producing a dummy gate on a first part of a semiconducting layer;
- producing superconducting electrodes such that the first part of the semiconducting layer comprises side edges, or side walls or side flanks, arranged against parts of the superconducting electrodes, the step of producing the superconducting electrodes comprising at least a deposition of a layer of a first superconducting material having first parts arranged against side edges of the dummy gate and second parts forming the superconducting electrodes or being parts of the superconducting electrodes;
- producing lateral spacers next to the first parts of the layer of the first superconducting material and on the second parts of the first superconducting material layer;
- removing the dummy gate and the first parts of the layer of the first superconducting material, creating a gate location arranged between the lateral spacers and above the first part of the semiconducting layer and above said parts of the superconducting electrodes;
- producing a gate in the gate location.

This method thus proposes a gate-last process which enables to obtain a gate that is self-aligned with the superconducting electrodes.

Another advantage is that this method is compatible with many High-Tc superconducting material like metal silicide.

A further advantage is that the superconducting electrodes are produced against the first part of the semiconducting layer which forms the weak link between the superconducting electrodes, making it possible to obtain a Josephson effect between the superconducting electrodes.

Advantageously, the method may be such that:
- the dummy gate may comprise first and second portions such that the first portion is arranged between the second portion and the first part of the semiconducting layer, and
- the method may further comprise, between the production of the dummy gate and the deposition of the first superconducting material layer, an etching of side edges of the first portion of the dummy gate, creating cavities between the second portion of the dummy gate and the first part of the semiconducting layer, and
- the deposition of the first superconducting material layer may be carried out such that the first superconducting material layer is not deposited in the cavities.

Thanks to these cavities, which can be filled by a dielectric material before the etching of the dummy gate, the superconducting material of the superconducting electrodes is not damaged during the removal of the dummy gate.

According to a first embodiment, the method may further comprise, before the production of the superconducting electrodes, a partial etching of second parts of the semiconducting layer contiguous to the first part of the semiconducting layer such that a part of the side edges of the first part of the semiconducting layer is exposed,
and the first superconducting material layer may then be deposited such that the second parts of the first superconducting material layer are arranged against the part of the side edges of the first part of the semiconducting layer.

According to a variant of the first embodiment:
- the semiconducting layer may correspond to a superficial layer of a semiconductor-on-insulator substrate, and
- the method may further comprise, before the production of the superconducting electrodes, a full etching of second parts of the semiconducting layer contiguous to the first part of the semiconducting layer such that the side edges of the first part of the semiconducting layer are exposed, and
- the first superconducting material layer may then be deposited such that the second parts of the first superconducting material layer located in the superconducting electrode locations create the superconducting electrodes.

According to a second embodiment:
- the production of the superconducting electrodes may further comprise doping and annealing of second parts of the semiconducting layer contiguous to the first part of the semiconducting layer, forming first parts of the superconducting electrodes against side edges of the first part of the semiconducting layer;
- the first superconducting material layer may then be deposited such that the second parts of the first superconducting material layer are located on the first parts of the superconducting electrodes and form second parts of the superconducting electrodes.

The configuration according to this second embodiment is advantageous because the first parts of the superconducting electrodes made as proposed in this embodiment enable to obtain a better interface with the semiconducting layer toward Andreev Reflection, and the second parts of the superconducting electrodes can be produced with a high-Tc superconducting material.

The method may further comprise, between the production of the superconducting electrodes and the production of the lateral spacers, a conformal deposition of a dielectric layer on the first superconducting material layer, the lateral spacers being produced against parts of the dielectric layer.

In an advantageous configuration, the dielectric layer may also be deposited such that the cavities are filled by the dielectric layer.

The method may further comprise, after the production of the gate, a step of producing electrical contacts on the gate and on the superconducting electrodes, the electrical contacts comprising advantageously at least a second superconducting material (which may be similar or not to the first superconducting material).

The method may further comprise, between the production of the lateral spacers and the removal of the dummy gate, an etching of parts of the first superconducting material layer arranged outside an active zone of the superconducting transistor.

Throughout the document, the term "on" is used irrespective of the spatial direction of the component to which the term refers. For example, in the characteristic "on at least a first surface of a component", this first surface is not necessarily directed upwards, but may be a surface facing in any other direction. Furthermore, the arrangement of a first component on a second component is to be understood as possibly being the arrangement of the first component directly against the second component, without any intermediate component between the first and second components, or as possibly being the arrangement of the first component on the second component with one or more intermediate components arranged between the first and second components. Furthermore, the arrangement of a first component on a second component does not necessarily imply that the first component is directed upwards and the second component is directed downwards.

### BRIEF DESCRIPTION OF DRAWINGS

The present invention will be better understood on reading the description of examples of embodiments given purely by way of illustration and by no means limitatively with reference to the annexed drawings wherein:
- Figs. 1 to 15 show the steps of a method for producing a superconducting transistor according to a first embodiment;
- Fig. 16 shows a superconducting transistor obtained according to an alternative of the first embodiment;
- Figs. 17 to 24 show the steps of a method for producing a superconducting transistor according to a second embodiment.

Identical, similar or equivalent parts of the various figures described hereunder bear the same numerical references so as to facilitate the transition from one figure to another.

The different parts shown in the figures are not necessarily presented in a uniform scale, in order to make the figures more legible.

The various possibilities (variants and embodiments) should be understood as not being exclusive of each other and may be combined with each other.

### DETAILED DESCRIPTION OF PARTICULAR EMBODIMENTS

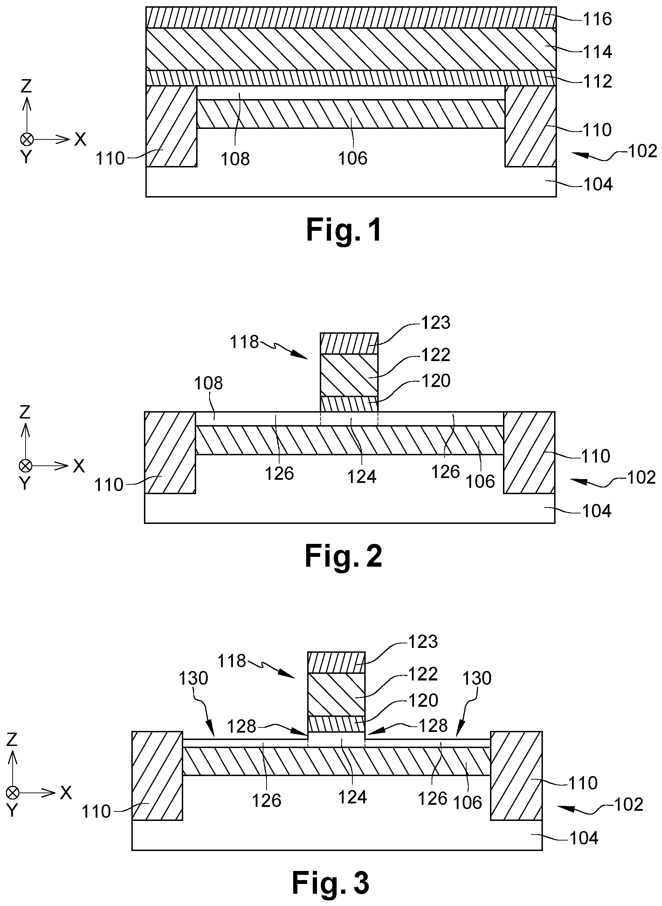

A method for producing a superconducting transistor 100 according to a first embodiment is described below in relation with Figs. 1 to 15. In these figures, the production of only one transistor 100 is shown. However, the method is implemented to produce simultaneously several superconducting transistors on the same substrate.

In the example shown and disclosed in relation with Figs. 1 to 15, the superconducting transistor 100 corresponds to a Josephson field-effect transistor.

As shown in Fig. 1, a substrate 102 is provided. In the example shown in Figs. 1 to 15, the substrate 102 is a semiconductor-on-insulator substrate, advantageously a Silicon-On-Insulator (SOI) substrate, comprising a bulk layer 104, a dielectric layer 106 and a semiconducting layer 108 forming a superficial layer of the substrate 102. The bulk layer 104 may comprise silicon. The dielectric layer 106, arranged between the bulk layer 104 and the semiconducting layer 108, may correspond to a BOX, or buried-oxide, comprising SiO₂. The semiconducting layer 108 may comprise silicon. Other materials may be used for the layers 104, 106 and 108.

For example, the thickness of the bulk layer 104 may be equal to several hundreds of microns, the thickness of the dielectric layer 106 may be between 20 nm and 500 nm, and the thickness of the semiconducting layer 108 may be between 10 nm and 50 nm, or thicker than 50 nm, and advantageously equal to 30 nm.

Insulation trenches 110 are produced in the substrate 102 in order to delimit the active zone in which the transistor 100 is intended to be produced. In the example here described, the trenches correspond to STI (Shallow Trench Isolation) trenches and are produced through the semiconducting layer 108, the dielectric layer 106 and a part of the thickness of the bulk layer 104.

A stack of layers intended to be used for the production of a dummy gate is then deposited on the substrate 102, i.e. on the semiconducting layer 108 and on the top of the insulation trenches 110. This stack includes a first layer 112 comprising a dielectric material, e.g. SiO₂, and a second layer 114 comprising polycrystalline silicon or silicide for example. The thickness of the first layer 112 may be between 1 nm and 20 nm, and the thickness of the second layer 114 may be between 10 nm and 100 nm, and advantageously between 30 nm and 80 nm. The materials of the layers 112, 114 are chosen such that they can be etched selectively one to the other. As explained below, the materials of the layers 112, 114 are also chosen such that they can be selectively etched against the materials which will surround the dummy gate.

A hard mask layer 116 is then deposited on the second layer 114. In the example here described, the hard mask layer 116 comprises a nitride insulator, e.g. SiNₓ.

The hard mask layer 116, and then the layers 112 and 114, are etched according to the desired pattern (in a plane parallel to (X,Y) plane) of the dummy gate. The obtained dummy gate, referenced 118, is shown in Fig. 2, and comprises a first portion 120 corresponding to a remaining portion of the first layer 112, and a second portion 122 corresponding to a remaining portion of the second layer 114. The hard mask used to etch the layers 112 and 114 is referenced 123. The dummy gate 118 is located on a first part 124 of the semiconducting layer 108. Second parts of the semiconducting layer 108 which are contiguous to the first part 124 (and thus which are not covered by the dummy gate 118) are referenced 126. In Figs. 2-15, the first part 124 and the second parts 126 of the semiconducting layer 108 are symbolically delimited one to the other by dotted lines.

The second parts 126 of the semiconducting layer 108 are then partially etched, i.e. only a part of the thickness (dimension parallel to Z axis) of the material of the second parts 126 is etched. This etching may correspond to a dry etching carried out using plasma, or to oxidation / oxide removal steps. After this partial etching, a part of side edges 128 of the first part 124 of the semiconducting layer 108 are exposed, as shown in Fig. 3. This partial etching of the second parts 126 of the semiconducting layer 108 creates locations 130 on the remaining portions of the second parts 126 of the semiconducting layer 108 and wherein superconducting electrodes of the transistor 100 are intended to be produced. The part of the thickness of the second parts 126 of the semiconducting layer 108 which is etched is chosen such that it corresponds to the thickness of the superconducting electrodes which will be produced, and may be between 30 % and 50 % of the initial thickness of the semiconducting layer 108.

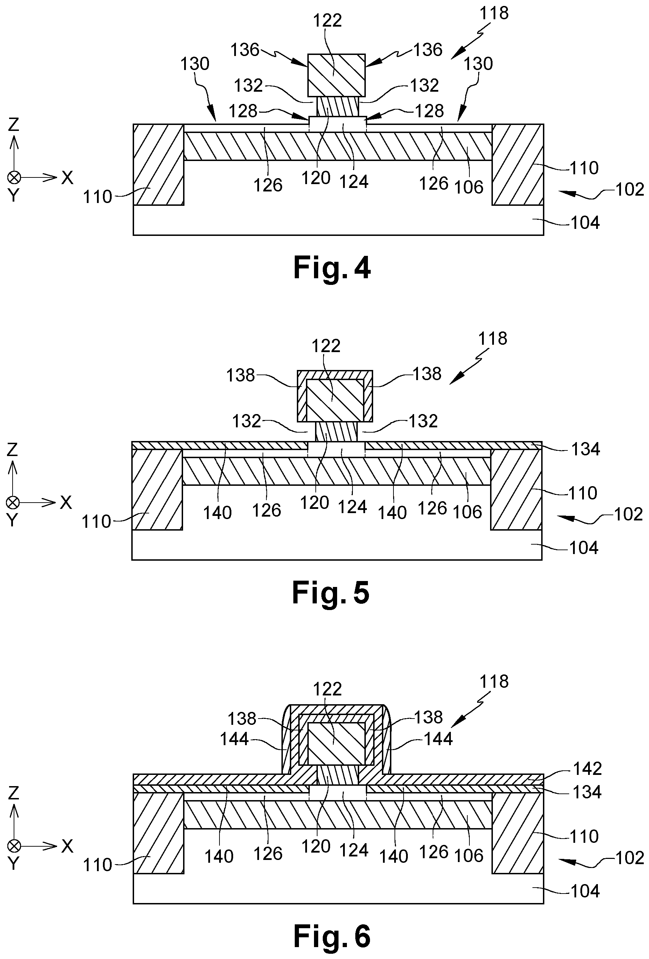

An etching, e.g. an isotropic wet etching using HF solution, of side edges of the first portion 120 of the dummy gate 118 is then carried out, creating cavities 132 between the second portion 122 of the dummy gate 118 and the first part 124 of the semiconducting layer 108. The depth of each of the cavities 132 (dimension parallel to the X axis shown in Fig. 4), which corresponds to the lateral encroachment etched in the material of the first portion 120 on each side of the dummy gate 118, may be between 1 nm and 5 nm. As shown in Fig. 4, this etching also etches top of the dielectric material of the insulation trenches 110. The hard mask 123 is then removed.

Superconducting electrodes of the transistor 100 are then produced such that the side edges 128 of the first part 124 of the semiconducting layer 108 are arranged against parts of the superconducting electrodes. In the first embodiment, the superconducting electrodes are produced by a deposition of a layer 134 comprising a first superconducting material, at least in locations 130 of the electrodes and against side edges 136 of the second portion 122 of the dummy gate 118. In the example shown in Fig. 5, the first superconducting material layer 134 is also deposited on top of the dummy gate 118. The parts of the first superconducting material layer 134 deposited against side edges 136 of the second portion 122 of the dummy gate 118 are named first parts 138 of the first superconducting material layer 134. Second parts 140 of the first superconducting material layer 134 located in the superconducting electrode locations 130 correspond to the superconducting electrodes of the transistor 100 in this first embodiment.

The first superconducting material of the layer 134 may correspond to at least one of the following metal silicides: CoSi₂, V₃Si, PtSi, Nb₃Si. In this case, an anneal is then carried out to convert the deposited metal films to superconducting silicide films. It may also correspond to TiN or any other superconducting material which can be deposited as previously described. If the first superconducting material of the layer 134 is TiN, no subsequent anneal is needed. The thickness of the first superconducting material layer 134 may be between 1 nm and 20 nm, and advantageously between 5 nm and 10 nm.

Advantageously, the deposition of the first superconducting material layer 134 is carried out such that this layer 134 is not deposited in the cavities 132, i.e. such that the layer 134 is not deposited on the first part 124 of the semiconducting layer 108. Thus, the deposition of the layer 134 carried out is not a conformal deposition. For example, the first superconducting material layer 134 may be deposited by carrying out a physical deposition, e.g. PVD (Physical Vapor Deposition), or low-conformality CVD (Chemical Vapor Deposition).

A conformal deposition of a dielectric layer 142 is then carried out on the first superconducting material layer 134. The dielectric layer 142 may correspond to an oxide layer, e.g. comprising at least one of the following materials: SiO_{X}, HfO_{X}, AlO_{X}, etc., deposited by means of ALD (Atomic Layer Deposition) for example, or PE-CVD (Plasma Enhanced Chemical Vapor Deposition). In the example here described, the layer 142 comprises SiO₂. The thickness of the dielectric layer 142 and the type of deposition implemented are chosen such that the dielectric layer 142 forms a continuous layer arranged on the second parts 140 of the first semiconducting material layer 134 and filling the cavities 132.

Lateral spacers 144 are then produced next to the first parts 138 of the layer 134, here against the parts of the dielectric layer 142 which are arranged against these first parts 138, and on the second parts 140 of the first superconducting material layer 134. The lateral spacers 144 may be obtained by the deposition of a dielectric material layer, e.g. a nitride layer such as a SiN layer, and a partial etching of this layer such that remaining parts of this layer correspond to the lateral spacers 144. The deposition of the nitride material layer may correspond to an ALD (Atomic Layer Deposition) or a CVD, and the thickness of the deposited nitride layer (dimension according to X axis shown in Fig. 6) may be between 5 nm and 10 nm.

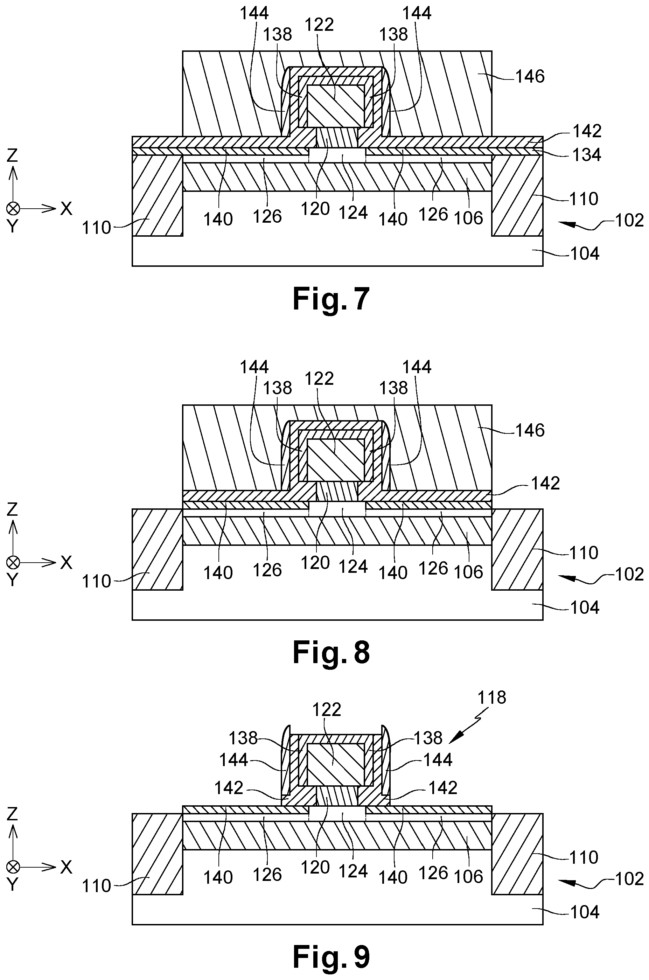

A resist mask 146 covering an active zone of the transistor 100, i.e. covering parts of the dielectric layer 142 arranged against the dummy gate 118 and on the second parts 140 of the layer 134, is then produced (see Fig. 7).

As shown in Fig. 8, an etching of the parts of the dielectric layer 142 and of the first superconducting material layer 134 arranged next to the locations of the electrodes 140, outside the active zone of the transistor 100, is then carried out. The type of this etching is adapted to the materials to be etched, and may correspond to a dry etching (e.g. plasma etching) and/or a wet etching.

The resist mask 146 and the parts of the dielectric layer 142 which are not protected by the lateral spacers 144 are then removed by etching (see Fig. 9). After this etching, the second parts 140 of the first superconducting material layer 134, i.e. the superconducting electrodes, are exposed. The part of the dielectric layer 142 arranged on top of the dummy gate 118 is then removed.

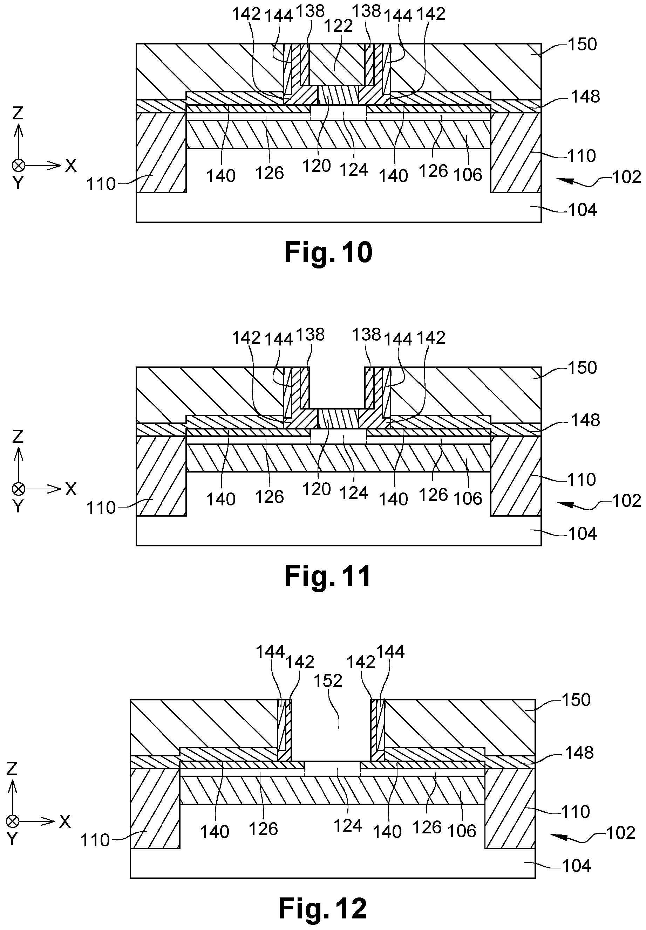

A nitride layer 148 is then deposited such that it covers all the elements produced on the substrate 102, and a thick oxide layer 150 is then deposited on the nitride layer 148. The total thickness of the layers 148+150 is larger than the sum of the thicknesses of the dummy gate 118 and the dielectric layer 142. A planarization, e.g. CMP (Chemical-Mechanical Polishing), is then carried out with stop on top of the dummy gate 118, i.e. on the second portion 122 of the dummy gate 118. The structure obtained at this stage of the method is shown in Fig. 10.

As a variant, it is possible to deposit the oxide layer 150 only, without the nitride layer 148.

As shown in Fig. 11, the second portion 122 of the dummy gate 112 is then removed by etching selectively the second portion 122 of the dummy gate 118 in view of the other exposed materials (the first superconducting material of the first parts 138 of the layer 134, the oxide layer 150, the dielectric layer 142, the first portion 120 of the dummy gate 1118). As an example, this etching may correspond to a wet etching carried out with a TMAH (Tetramethylammonium hydroxide) solution.

As shown in Fig. 12, the removal of the dummy gate 118 is finished by removing the first portion 120 of the dummy gate 118, e.g. with a wet etching carried out with an HF (hydrofluoric acid) solution. This etching also removes the parts of the dielectric layer 142 contiguous to the first portion 120 of the dummy gate 118 and covered by the first parts 138 of the first superconducting material layer 134. Then these first parts 138 are removed, e.g. by lift-off. Thanks to the dielectric material of the dielectric layer 142 deposited in the cavities 132, the removal of the first parts 138 of the first superconducting material layer does not damage the second parts 140 of the first superconducting material layer 134. A surface cleaning, e.g. with a HNO₃ solution or a H₂SO₄ + H₂O₂ solution, is then carried out.

The removal of the dummy gate 118 and of the first parts 138 of the first superconducting material layer 134 forms a gate location 152 arranged between the lateral spacers 144 (and between remaining parts of the dielectric layer 142 in the example here described) and above the first part 124 of the semiconducting layer 108, and also above parts of the superconducting electrodes (corresponding to the second parts 140 of the first superconducting material layer 134) contiguous to the first part 124 of the semiconducting layer 108.

As a variant, it is possible to completely etch the dielectric layer 142 and the first portion 120 of the dummy gate 118. The first parts 138 of the layer 134 are thus removed by lift-off.

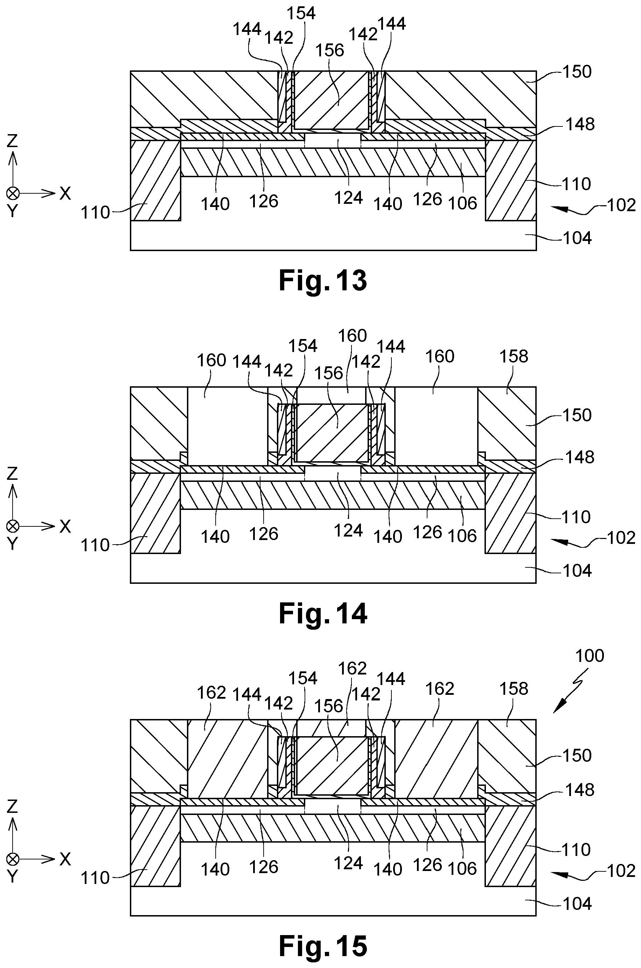

A gate is then produced in the gate location 152 (see Fig. 13). The gate is made, in this example, by a conformal deposition of a dielectric layer and a deposition of a conductive material which, together, fill the gate location 152. The parts of these layers deposited outside the gate location 152 are then removed by CMP. The remaining parts of these layers correspond to a gate dielectric 154 and a gate conductor 156 forming together the gate of the transistor 100. The gate dielectric 154 may comprise e.g. a high-K material or SiO₂, and the gate conductor 156 may comprise at least one metal, doped polycrystalline semiconductor or advantageously a second superconducting material (which may correspond or not to the first superconducting material).

A PMD (Pre-Metal Dielectric) layer 158 is then deposited. This PMD layer may comprise the same dielectric material as the oxide layer 150. Contact holes 160 are then etched through the PMD layer 158 to expose the top of the gate conductor 156, and also through the oxide layer 150 to expose the top of the superconducting electrodes formed by the second parts 140 of the first superconducting material layer 134 (see Fig. 14).

Electrical contacts 162 are then produced by deposition of at least one conductive material in the contact holes 160 (see Fig. 15). Advantageously, the electrical contacts 162 comprise a third superconducting material which may be similar or not to the first superconducting material of the layer 134 and/or to the second superconducting material of the gate conductor 156. However, it is possible to make electrical contacts 162 with other types of conductive materials: doped polycrystalline silicon, doped SiGe, TiN, TaN, metal silicide, W, TiW, Al, Cu, etc.

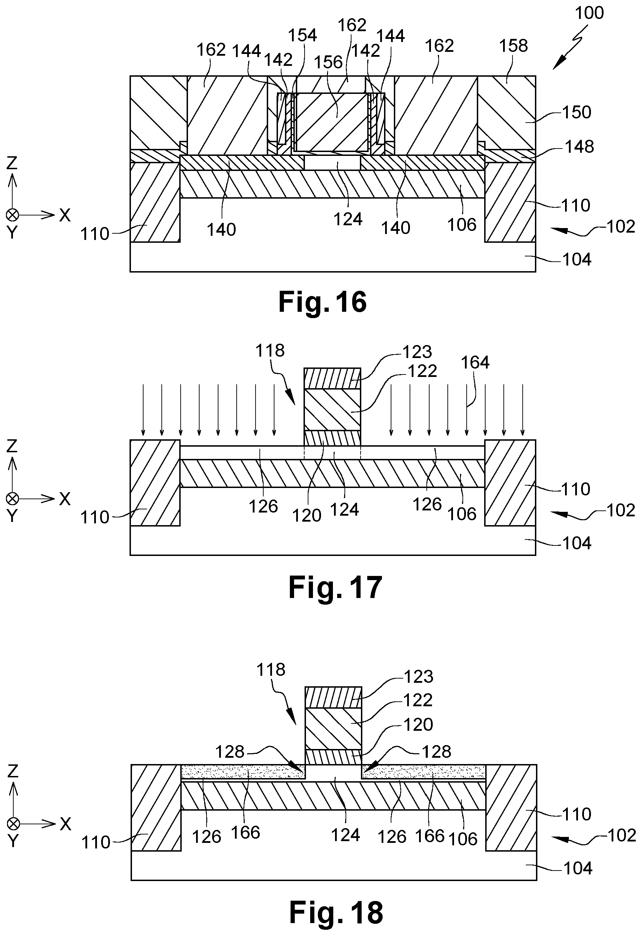

In the first embodiment previously described, the semiconducting layer 108 is etched only through a part of its total thickness such that second parts 126 are kept next to the first part 124 arranged below the dummy gate 118. In a variant, the second parts 126 of the semiconducting layer 108 which are not covered by the dummy gate 118 may be completely etched. In this case, the first superconducting material layer 134/140 is deposited directly on parts of the dielectric layer 106 exposed after the etching of the second parts 126 of the semiconducting layer 108 and the second parts 140 of the first superconducting material layer 134 are arranged against the side edges 128 of the first part 124 of the semiconducting layer 108. The transistor 100 thus obtained is shown in Fig. 16. In this variant, it is also possible, as previously described for the first embodiment, to completely etch the dielectric layer 142 and the first portion 120 of the dummy gate 118 before producing the gate.

A method for producing a transistor 100 according to a second embodiment is described below in relation to Figs. 17 to 24. In these figures, the production of one transistor 100 is shown. However, this method is implemented to produce simultaneously several transistors on the same substrate.

Similarly to the first embodiment, the substrate 102 is provided. The insulation trenches 110 are produced in the substrate 102 and the stack of layers intended to be used for the production of the dummy gate 118 is then deposited. The hard mask layer is then deposited. The hard mask layer and the dummy gate stack layers are then etched according to the desired pattern of the dummy gate 118.

Contrary to the first embodiment wherein the second parts 126 of the semiconducting layer 108 are partially or completely etched, the method according to the second embodiment does not include an etching of these second parts 126. In this second embodiment, the production of the superconducting electrodes comprises doping and annealing of the second parts 126 of the semiconducting layer 108. In the example here described, the doping of the second parts 126 correspond to a boron implantation, symbolically shown by arrows 164 in Fig. 17. The annealing which is carried out after the doping activates the implanted dopants and may correspond to a laser annealing. These steps create, in the second parts 126 of the semiconducting layer 108, first parts (referenced 166 in Fig. 18) of the superconducting electrodes against the side edges 128 of the first part 124 of the semiconducting layer 108, these first parts 166 being arranged in the superconducting electrode locations 130.

As previously described for the first embodiment, an etching of side edges of the first portion 120 of the dummy gate 118 is then carried out, creating the cavities 132 between the second portion 122 of the dummy gate 118 and the first part 124 of the semiconducting layer 108. The hard mask 123 is then removed.

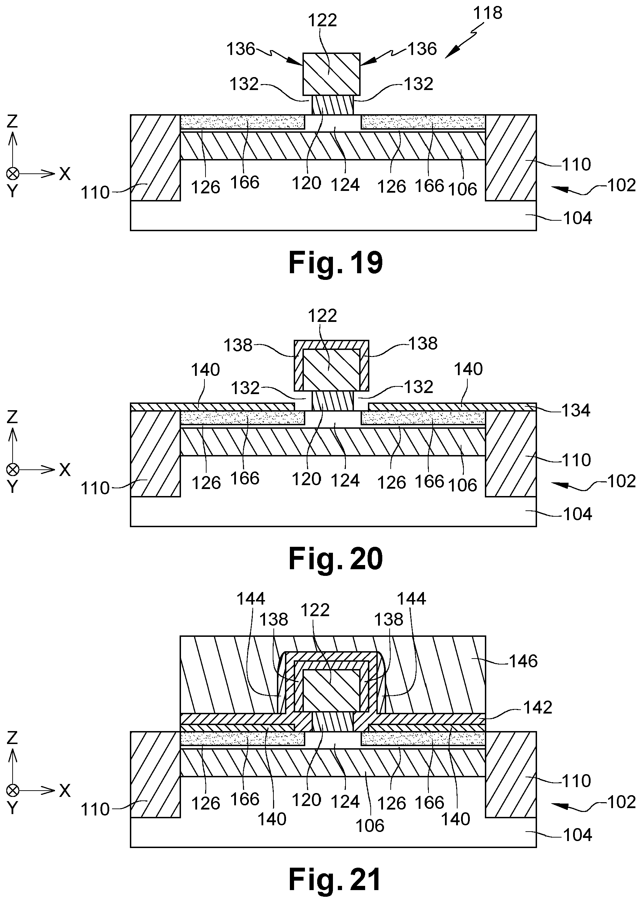

The second parts of the superconducting electrodes of the transistor 100 are then produced by depositing the first superconducting material layer 134 on the first parts 166 of the superconducting electrodes (i.e. on the superconducting electrodes locations 130) and against the side edges 136 of the second portion 122 of the dummy gate 118 (see Fig. 20). In the example shown in Fig. 20, the first superconducting material layer 134 is also deposited on top of the dummy gate 118. The second parts 140 of the first superconducting material layer 134 located above the first parts 166 of the superconducting electrodes form the second parts of the superconducting electrodes of the transistor 100. Similarly to the first embodiment, the deposition of the first superconducting material layer 134 is carried out such that this first superconducting material layer 134 is not deposited in the cavities 132, i.e. such that the layer 134 is not deposited on the first part 124 of the semiconducting layer 108. In this second embodiment, because the superconducting electrodes also comprise the first parts 166, the first superconducting material of the layer 134 may be Ta or TaN, or one of the superconducting material previously described in relation with the first embodiment.

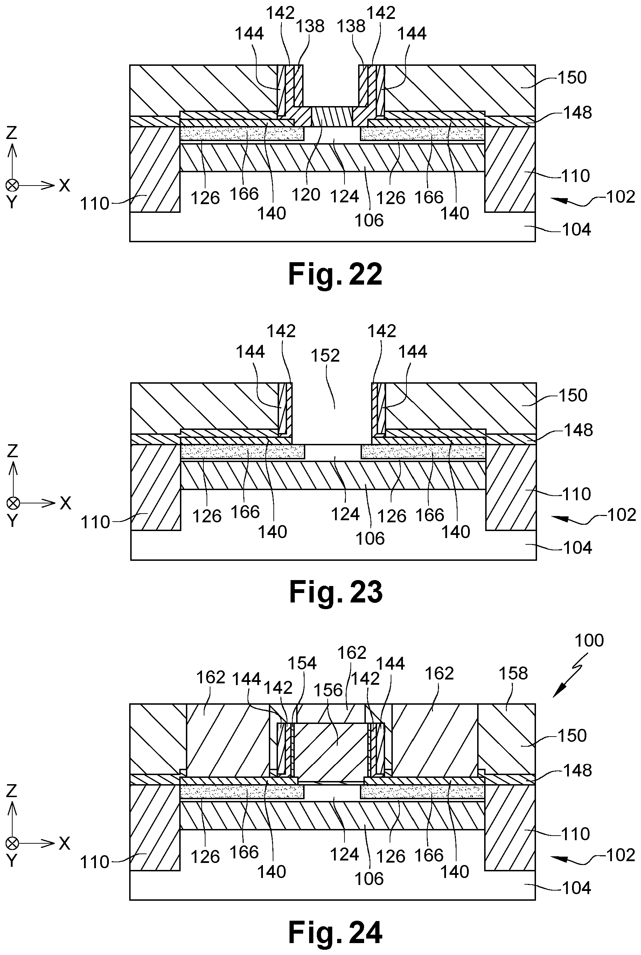

The steps of the method according to the second embodiment which are then carried out are similar to those previously described for the first embodiment, i.e.:
- conformal deposition of the dielectric layer 142 on the first superconducting material layer 134 and also in the cavities 132;
- producing the lateral spacers 144 next to the first parts 138 of the first superconducting material layer 134, against the parts of the dielectric layer 142;
- producing the resist mask 146;
- etching the material of the dielectric layer 142 and the first superconducting material of the layer 134 not covered by the resist mask 146 (see Fig. 21);
- removing the resist mask 146, the parts of the dielectric layer 142 which are not protected by the lateral spacers 144 and the part of the dielectric layer 142 arranged on top of the dummy gate 118;
- depositing the nitride layer 148 and the thick oxide layer 150;
- planarization with stop on the dummy gate 118;
- removing the second portion 122 of the dummy gate 118 (see Fig. 22);
- removing the first portion 120 of the dummy gate 118 and the parts of the dielectric layer 142 contiguous to the first part 120 of the dummy gate 118 and covered by the first parts 138 of the first superconducting material layer 134;
- removing the first parts 138 of the first superconducting material layer 134;
- surface cleaning (see Fig. 23);
- producing the gate (gate dielectric 154 + gate conductor 156) in the gate location 152;
- deposition of the PMD layer 158;
- etching of the contact holes 160;
- producing the electrical contacts 162.

The transistor 100 obtained at the end of the method according to the second embodiment is shown in Fig. 24.

The different options and variants previously disclosed in relation with the first embodiment can be applied to the second embodiment. Especially, it is possible to form the gate location 52 by completely etching the dielectric layer 142 and the first portion 120 of the dummy gate 118. The first parts 138 of the layer 134 are thus removed by lift-off.

In the previously described embodiments, the substrate 102 corresponds to a SOI substrate. Alternatively, the substrate 102 may correspond to a semiconductor bulk substrate, e.g. a silicon bulk substrate.

In the previously described embodiments, the first part 120 of the dummy gate 118 is etched and the cavities 132 are filled with the material of the dielectric layer 142. As a variant, it is possible to not etch the first part 120 of the dummy gate 118. In this case, the first and second parts 138, 140 of the first superconducting material layer 134 are not separated by the cavities 132. In this case, during the production of the gate location 152, the etching of the first parts 138 of the first superconducting material layer 134 has to be carefully implemented to cause as little damage as possible to the second parts 140 of the first superconducting material layer 134.

In another variant, when the first part 120 of the dummy gate 118 is not etched, it is possible to not deposit the dielectric layer 142 and to make the lateral spacers 144 directly against the parts 138 of superconducting material.

In all the previously described embodiments and variants, is it possible to produce the dummy gate 118 with only one material.

## Claims

1. Method for producing a superconducting transistor (100), comprising at least the steps of:
- producing a dummy gate (118) on a first part (124) of a semiconducting layer (108);
- producing superconducting electrodes (140, 166) such that the first part (124) of the semiconducting layer (108) comprises side edges (128) arranged against parts of the superconducting electrodes (140, 166), the step of producing superconducting electrodes (140, 166) comprising at least a deposition of a first superconducting material layer (134) having first parts (138) arranged against side edges (136) of the dummy gate (118) and second parts (140) forming the superconducting electrodes (140, 166) or being parts of the superconducting electrodes (140, 166);
- producing lateral spacers (144) next to the first parts (138) of the first superconducting material layer (134) and on the second parts (140) of the first superconducting material layer (134);
- removing the dummy gate (118) and the first parts (138) of the first superconducting material layer (134), creating a gate location (152) arranged between the lateral spacers (144) and above the first part (124) of the semiconducting layer (108) and above said parts of the superconducting electrodes (140, 166);
- producing a gate (154, 156) in the gate location (152).

2. Method according to claim 1, wherein:
- the dummy gate (118) comprises first and second portions (120, 122) such that the first portion (120) is arranged between the second portion (122) and the first part (124) of the semiconducting layer (108), and
- the method further comprises, between the production of the dummy gate (118) and the deposition of the first superconducting material layer (134), an etching of side edges of the first portion (120) of the dummy gate (118), creating cavities (132) between the second portion (122) of the dummy gate (118) and the first part (124) of the semiconducting layer (108), and
- the deposition of the first superconducting material layer (134) is carried out such that the first superconducting material layer (134) is not deposited in the cavities (132).

3. Method according to one of previous claims, further comprising, before the production of the superconducting electrodes (140), a partial etching of second parts (126) of the semiconducting layer (108) contiguous to the first part (124) of the semiconducting layer (108) such that a part of the side edges (128) of the first part (124) of the semiconducting layer (108) is exposed,
and wherein the first superconducting material layer (134) is then deposited such that second parts (140) of the first superconducting material layer (134) are arranged against the part of the side edges (128) of the first part (124) of the semiconducting layer (108).

4. Method according to one of claims 1 and 2, wherein the semiconducting layer (108) corresponds to a superficial layer of a semiconductor-on-insulator substrate (102), and
further comprising, before the production of the superconducting electrodes (140), a full etching of second parts (126) of the semiconducting layer (108) contiguous to the first part (124) of the semiconducting layer (108) such that the side edges (128) of the first part (124) of the semiconducting layer (108) are exposed,
and wherein the first superconducting material layer (134) is then deposited such that the second parts (140) of the first superconducting material layer (134) are arranged against the side edges (128) of the first part (124) of the semiconducting layer (108).

5. Method according to one of claims 1 and 2, wherein:
- the production of the superconducting electrodes (140, 166) further comprises doping and annealing of second parts (126) of the semiconducting layer (108) contiguous to the first part (124) of the semiconducting layer (108), forming first parts (166) of the superconducting electrodes (140, 166) against side edges (128) of the first part (124) of the semiconducting layer (108);
- the first superconducting material layer (134) is then deposited such that the second parts (140) of the first superconducting material layer (134) are located on the first parts (166) of the superconducting electrodes (140, 166) and form second parts of the superconducting electrodes.

6. Method according to one of previous claims, further comprising, between the production of the superconducting electrodes (140, 166) and the production of the lateral spacers (144), a conformal deposition of a dielectric layer (142) on the first superconducting material layer (134), the lateral spacers (144) being produced against parts of the dielectric layer (142).

7. Method according to claims 2 and 6, wherein the dielectric layer (142) is also deposited such that the cavities (132) are filled by the dielectric layer (142).

8. Method according to one of previous claims, wherein the production of the gate (154, 156) includes a deposition of at least a second superconducting material.

9. Method according to one of previous claims, further comprising, after the production of the gate (154, 156), a step of producing electrical contacts (162) on the gate (154, 156) and on the superconducting electrodes (140, 166), the electrical contacts (162) comprising at least a third superconducting material.

10. Method according to previous claims, further comprising, between the production of the lateral spacers (144) and the removal of the dummy gate (118), an etching of parts of the first superconducting material layer (134) arranged outside an active zone of the superconducting transistor (100).

## Patentansprüche

1. Verfahren zum Herstellen eines supraleitenden Transistors (100), das mindestens die folgenden Schritte umfasst:
- Herstellen eines Dummy-Gates (118) auf einem ersten Teil (124) einer halbleitenden Schicht (108);
- Herstellen von supraleitenden Elektroden (140, 166) derart, dass der erste Teil (124) der halbleitenden Schicht (108) Seitenkanten (128) umfasst, die an Teilen der supraleitenden Elektroden (140, 166) angeordnet sind, wobei der Schritt des Herstellens von supraleitenden Elektroden (140, 166) mindestens ein Abscheiden einer ersten supraleitenden Materialschicht (134) umfasst, die erste Teile (138), welche an Seitenkanten (136) des Dummy-Gates (118) angeordnet sind, und zweite Teile (140) aufweist, die die supraleitenden Elektroden (140, 166) bilden oder Teile der supraleitenden Elektroden (140, 166) sind;
- Herstellen von seitlichen Abstandshaltern (144) neben den ersten Teilen (138) der ersten supraleitenden Materialschicht (134) und auf den zweiten Teilen (140) der ersten supraleitenden Materialschicht (134);
- Entfernen des Dummy-Gates (118) und der ersten Teile (138) der ersten supraleitenden Materialschicht (134), Erzeugen einer Gate-Stelle (152), die zwischen den seitlichen Abstandshaltern (144) und oberhalb des ersten Teils (124) der halbleitenden Schicht (108) und oberhalb der Teile der supraleitenden Elektroden (140, 166) angeordnet ist;
- Herstellen eines Gates (154, 156) an der Gate-Stelle (152).

2. Verfahren nach Anspruch 1, wobei:
- das Dummy-Gate (118) einen ersten und einen zweiten Abschnitt (120, 122) derart umfasst, dass der erste Abschnitt (120) zwischen dem zweiten Abschnitt (122) und dem ersten Teil (124) der halbleitenden Schicht (108) angeordnet ist, und
- das Verfahren zwischen dem Herstellen des Dummy-Gates (118) und dem Abscheiden der ersten supraleitenden Materialschicht (134) weiter ein Ätzen von Seitenkanten des ersten Abschnitts (120) des Dummy-Gates (118) umfasst, wodurch Hohlräume (132) zwischen dem zweiten Abschnitt (122) des Dummy-Gates (118) und dem ersten Teil (124) der halbleitenden Schicht (108) erzeugt werden, und
- das Abscheiden der ersten supraleitenden Materialschicht (134) derart ausgeführt wird, dass die erste supraleitende Materialschicht (134) nicht in den Hohlräumen (132) abgeschieden wird.

3. Verfahren nach einem der vorstehenden Ansprüche, das vor dem Herstellen der supraleitenden Elektroden (140) weiter ein teilweises Ätzen von zweiten Teilen (126) der halbleitenden Schicht (108), die an den ersten Teil (124) der halbleitenden Schicht (108) angrenzen, derart umfasst, dass ein Teil der Seitenkanten (128) des ersten Teils (124) der halbleitenden Schicht (108) freigelegt wird,
und wobei die erste supraleitende Materialschicht (134) dann derart abgeschieden wird, dass zweite Teile (140) der ersten supraleitenden Materialschicht (134) an dem Teil der Seitenkanten (128) des ersten Teils (124) der halbleitenden Schicht (108) angeordnet werden.

4. Verfahren nach einem der Ansprüche 1 und 2, wobei die halbleitende Schicht (108) einer oberflächlichen Schicht eines Halbleiter-auf-Isolator-Substrates (102) entspricht, und
vor dem Herstellen der supraleitenden Elektroden (140) weiter ein vollständiges Ätzen von zweiten Teilen (126) der halbleitenden Schicht (108), die an den ersten Teil (124) der halbleitenden Schicht (108) angrenzen, derart umfassend, dass die Seitenkanten (128) des ersten Teils (124) der halbleitenden Schicht (108) freigelegt werden,
und wobei die erste supraleitende Materialschicht (134) dann derart abgeschieden wird, dass die zweiten Teile (140) der ersten supraleitenden Materialschicht (134) an den Seitenkanten (128) des ersten Teils (124) der halbleitenden Schicht (108) angeordnet werden.

5. Verfahren nach einem der Ansprüche 1 und 2, wobei:
- das Herstellen der supraleitenden Elektroden (140, 166) weiter das Dotieren und Ausheilen von zweiten Teilen (126) der halbleitenden Schicht (108), die an den ersten Teil (124) der halbleitenden Schicht (108) angrenzen, umfasst, wodurch erste Teile (166) der supraleitenden Elektroden (140, 166) an Seitenkanten (128) des ersten Teils (124) der halbleitenden Schicht (108) gebildet werden;
- die erste supraleitende Materialschicht (134) dann derart abgeschieden wird, dass sich die zweiten Teile (140) der ersten supraleitenden Materialschicht (134) auf den ersten Teilen (166) der supraleitenden Elektroden (140, 166) befinden und zweite Teile der supraleitenden Elektroden bilden.

6. Verfahren nach einem der vorstehenden Ansprüche, das zwischen dem Herstellen der supraleitenden Elektroden (140, 166) und dem Herstellen der seitlichen Abstandshalter (144) weiter ein konformes Abscheiden einer dielektrischen Schicht (142) auf der ersten supraleitenden Materialschicht (134) umfasst, wobei die seitlichen Abstandshalter (144) an Teilen der dielektrischen Schicht (142) hergestellt werden.

7. Verfahren nach den Ansprüchen 2 und 6, wobei die dielektrische Schicht (142) ebenfalls derart abgeschieden wird, dass die Hohlräume (132) durch die dielektrische Schicht (142) gefüllt werden.

8. Verfahren nach einem der vorstehenden Ansprüche, wobei das Herstellen des Gates (154, 156) ein Abscheiden von mindestens einem zweiten supraleitenden Material beinhaltet.

9. Verfahren nach einem der vorstehenden Ansprüche, das nach dem Herstellen des Gates (154, 156) weiter einen Schritt des Herstellens von elektrischen Kontakten (162) am Gate (154, 156) und an den supraleitenden Elektroden (140, 166) umfasst, wobei die elektrischen Kontakte (162) mindestens ein drittes supraleitendes Material umfassen.

10. Verfahren nach vorstehenden Ansprüchen, das zwischen dem Herstellen der seitlichen Abstandshalter (144) und dem Entfernen des Dummy-Gates (118) weiter ein Ätzen von Teilen der ersten supraleitenden Materialschicht (134), die außerhalb einer aktiven Zone des supraleitenden Transistors (100) angeordnet sind, umfasst.

## Revendications

1. Procédé de production d'un transistor supraconducteur (100), comportant au moins les étapes suivantes :
- la production d'une grille factice (118) sur une première partie (124) d'une couche semi-conductrice (108) ;
- la production d'électrodes supraconductrices (140, 166) de sorte que la première partie (124) de la couche semi-conductrice (108) comporte des bords latéraux (128) agencés contre des parties des électrodes supraconductrices (140, 166), l'étape de production d'électrodes supraconductrices (140, 166) comportant au moins un dépôt d'une première couche de matériau supraconducteur (134) ayant de premières parties (138) agencées contre des bords latéraux (136) de la grille factice (118) et de deuxièmes parties (140) formant les électrodes supraconductrices (140, 166) ou faisant partie des électrodes supraconductrices (140, 166) ;
- la production d'espaceurs latéraux (144) à côté des premières parties (138) de la première couche de matériau supraconducteur (134) et sur les deuxièmes parties (140) de la première couche de matériau supraconducteur (134) ;
- le retrait de la grille factice (118) et des premières parties (138) de la première couche de matériau supraconducteur (134), créant un emplacement de grille (152) agencé entre les espaceurs latéraux (144) et au-dessus de la première partie (124) de la couche semi-conductrice (108) et au-dessus desdites parties des électrodes supraconductrices (140, 166) ;
- la production d'une grille (154, 156) dans l'emplacement de grille (152).

2. Procédé selon la revendication 1, dans lequel :
- la grille factice (118) comporte de première et deuxième parties (120, 122) de sorte que la première partie (120) soit agencée entre la deuxième partie (122) et la première partie (124) de la couche semi-conductrice (108), et
- le procédé comporte en outre, entre la production de la grille factice (118) et le dépôt de la première couche de matériau supraconducteur (134), une gravure de bords latéraux de la première partie (120) de la grille factice (118), créant des cavités (132) entre la deuxième partie (122) de la grille factice (118) et la première partie (124) de la couche semi-conductrice (108), et
- le dépôt de la première couche de matériau supraconducteur (134) est réalisé de sorte que la première couche de matériau supraconducteur (134) ne soit pas déposée dans les cavités (132).

3. Procédé selon l'une des revendications précédentes, comportant en outre, avant la production des électrodes supraconductrices (140), une gravure partielle de deuxièmes parties (126) de la couche semi-conductrice (108) contiguës à la première partie (124) de la couche semi-conductrice (108) de sorte qu'une partie des bords latéraux (128) de la première partie (124) de la couche semi-conductrice (108) soit exposée,
et dans lequel la première couche de matériau supraconducteur (134) est ensuite déposée de sorte que de deuxièmes parties (140) de la première couche de matériau supraconducteur (134) soient agencées contre la partie des bords latéraux (128) de la première partie (124) de la couche semi-conductrice (108).

4. Procédé selon l'une des revendications 1 et 2, dans lequel la couche semi-conductrice (108) correspond à une couche superficielle d'un substrat semiconducteur sur isolant (102), et
comportant en outre, avant la production des électrodes supraconductrices (140), une gravure complète de deuxièmes parties (126) de la couche semi-conductrice (108) contiguës à la première partie (124) de la couche semi-conductrice (108) de sorte que les bords latéraux (128) de la première partie (124) de la couche semi-conductrice (108) soient exposés,
et dans lequel la première couche de matériau supraconducteur (134) est ensuite déposée de sorte que les deuxièmes parties (140) de la première couche de matériau supraconducteur (134) soient agencées contre les bords latéraux (128) de la première partie (124) de la couche semi-conductrice (108).

5. Procédé selon l'une des revendications 1 et 2, dans lequel :
- la production des électrodes supraconductrices (140, 166) comporte en outre le dopage et le recuit de deuxièmes parties (126) de la couche semi-conductrice (108) contiguës à la première partie (124) de la couche semi-conductrice (108), formant de premières parties (166) des électrodes supraconductrices (140, 166) contre des bords latéraux (128) de la première partie (124) de la couche semi-conductrice (108) ;
- la première couche de matériau supraconducteur (134) est ensuite déposée de sorte que les deuxièmes parties (140) de la première couche de matériau supraconducteur (134) soient situées sur les premières parties (166) des électrodes supraconductrices (140, 166) et forment de deuxièmes parties des électrodes supraconductrices.

6. Procédé selon l'une des revendications précédentes, comportant en outre, entre la production des électrodes supraconductrices (140, 166) et la production des espaceurs latéraux (144), un dépôt conforme d'une couche diélectrique (142) sur la première couche de matériau supraconducteur (134), les espaceurs latéraux (144) étant produites contre des parties de la couche diélectrique (142).

7. Procédé selon les revendications 2 et 6, dans lequel la couche diélectrique (142) est également déposée de sorte que les cavités (132) soient remplies par la couche diélectrique (142).

8. Procédé selon l'une des revendications précédentes, dans lequel la production de la grille (154, 156) inclut un dépôt d'au moins un deuxième matériau supraconducteur.

9. Procédé selon l'une des revendications précédentes, comportant en outre, après la production de la grille (154, 156), une étape de production de contacts électriques (162) sur la grille (154, 156) et sur les électrodes supraconductrices (140, 166), les contacts électriques (162) comportant au moins un troisième matériau supraconducteur.

10. Procédé selon les revendications précédentes, comportant en outre, entre la production des espaceurs latéraux (144) et le retrait de la grille factice (118), une gravure de parties de la première couche de matériau supraconducteur (134) agencées en dehors d'une zone active du transistor supraconducteur (100).
